Europäisches Patentamt

European Patent Office

Office européen des brevets

(11) Publication number: **0 406 024 B1**

# EUROPEAN PATENT SPECIFICATION

(45) Date of publication of patent specification: **14.09.94** (51) Int. Cl.5: **G01R 33/035**, G01R 33/06

(21) Application number: **90307187.6**

(22) Date of filing: **29.06.90**

(54) **Method and device for sensing a magnetic field with use of a magneto-resistive property of a superconductive material.**

(30) Priority: **30.06.89 JP 170303/89**
**30.06.89 JP 170306/89**

(43) Date of publication of application:
**02.01.91 Bulletin  91/01**

(45) Publication of the grant of the patent:
**14.09.94 Bulletin  94/37**

(84) Designated Contracting States:
**DE FR GB**

(56) References cited:
**EP-A- 0 262 879**
**CH-A- 315 359**

**JAPANESE JOURNAL OF APPLIED PHYSICS,
vol. 27, no. 5, 1988, pages 746-750,Tokyo, JP;
H. NOJIMA et al.: Galvanomagnetic effect of
an Y-Ba-Cu-O ceramic**

**superconductor and its application to magnetic sensors"**

**IBM TECHNICAL DISCLOSURE BULLETIN, vol.
32, no. 5A, 1989, pages 236-237,Armonk, NY,
US; "Temperature-stabilized magnetic field
sensor"**

(73) Proprietor: **SHARP KABUSHIKI KAISHA**
**22-22 Nagaike-cho**
**Abeno-ku**
**Osaka-shi Osaka 545 (JP)**

(72) Inventor: **Nojima, Hideo**
**65-10, Minaminagai-cho**
**Nara-shi, Nara-ken (JP)**
Inventor: **Shintaku, Hidetaka**
**18-207 Katsuragi-cho**
**Nara-shi, Nara-ken (JP)**
Inventor: **Koba, Masayoshi**
**51-14-5 Shichijonishimachi,**
**1-chome**
**Nara-shi, Nara-ken (JP)**

(74) Representative: **Brown, Kenneth Richard et al**
**R.G.C. Jenkins & Co.**
**26 Caxton Street**
**London SW1H 0RJ (GB)**

EP 0 406 024 B1

**Description**

BACKGROUND OF THE INVENTION

Field of the Invention

The present invention relates to a method and device for sensing a magnetic field with use of a magneto-resistive property of a superconductive material.

Description of the Prior Art

Conventionally, a magnetic sensor which utilizes the Hall effect or the magneto-resistive effect in a semiconductor or a magnetic sensor which utilizes the magneto-resistive effect in a magnetic material is widely used for sensing or measuring a magnetic field. These sensors have a limit of resolution of sensing a magnetic field of about $10^{-7}$ T ($10^{-3}$ gauss). Conventionally, for sensing a weak magnetic field, SQUID (Superconductive Quantum Interference Device) has been used. However, SQUID needs the Josephson junction which utilizes thin insulation layer between two thin superconductors, whereby a high production technology is necessary and it is not easy to produce the SQUID devices. In addition, in order to sense a magnetic field, it is necessary to cool the SQUID, to eliminate noise and to process the output signals from the SQUID. Therefore to handle the SQUID for the measurement of the magnetic field is not easy.

The inventors of the present invention have found that the superconductive state of a ceramic superconductive element breaks down on application of a small magnetic field due to the grain boundary property and the element acquires a resistance which increases abruptly corresponding to increment of the applied magnetic field. They propose a new magnetic field sensor utilizing the magneto-resistive effect. Refer, for example, to Japanese Journal of Applied Physics, Vol. 27, No. 5, May 1988, pages 746-750, H. Nojima et al: Galvanomagnetic Effect of an Y-Ba-Cu-O Ceramic Superconductor and Its Application to Magnetic Sensors. The magnetic sensor using the ceramic superconductor mentioned above is expected as the superconductor magnetic sensor having a high sensitivity with easy operation and handling in addition to easy production partly because the sensor has a large resistivity increasing factor at the time of application of such a magnetic field that the superconductive condition is broken and the structure of the device is simple and the control of the sensitivity of the device can be easily made by the application of current, partly because the measurement output can be easily obtained.

However, the property of the superconductor magneto-resistive element as mentioned above is non-linear in terms of the resistance and the applied magnetic field; therefore, it is difficult to calculate an absolute intensity of applied magnetic field based on the resistance value of the element.

Besides, there have been used various kinds of magnetic field sensor using high speed electron mobility semiconductors such as In Sb and In As, and ferro magnetic metal such as Fe-Ni, Co-Ni.

However, with the conventional magnetic field sensor using the above material it is difficult to sense a weak magnetic field accurately.

SUMMARY OF THE INVENTION

An essential object of the present invention is to provide a method of sensing the intensity of applied magnetic field accurately with a simple magnetic sensor.

In order to accomplish the purpose mentioned above, according to the present invention, a method of measuring magnetic field using a magneto-resistive element having a superconductor magneto-resistive property is characterised by applying a bias magnetic field to the magneto-resistive element using a coil, the coil being connected to a feedback power source for supplying current thereto for holding the output of the element of a constant value, whereby the applied magnetic field is measured by the current supplied to the coil. The intensity of the bias magnetic field may be so controlled as to cause the resistance value of the magneto-resistive element to coincide with a set resistance value at which the sensitivity of the element is high. Since the intensity of the magnetic field which makes the magneto-resistive element acquire the set resistance value is previously known, it is possible to accurately adjust the bias magnetic field utilizing the property of the magneto-resistive element in the high sensitivity state, and the intensity of the magnetic field can be represented by the amount of the current of the coil, whereby the outer magnetic field can be calculated based on the difference of the above mentioned two magnetic fields.

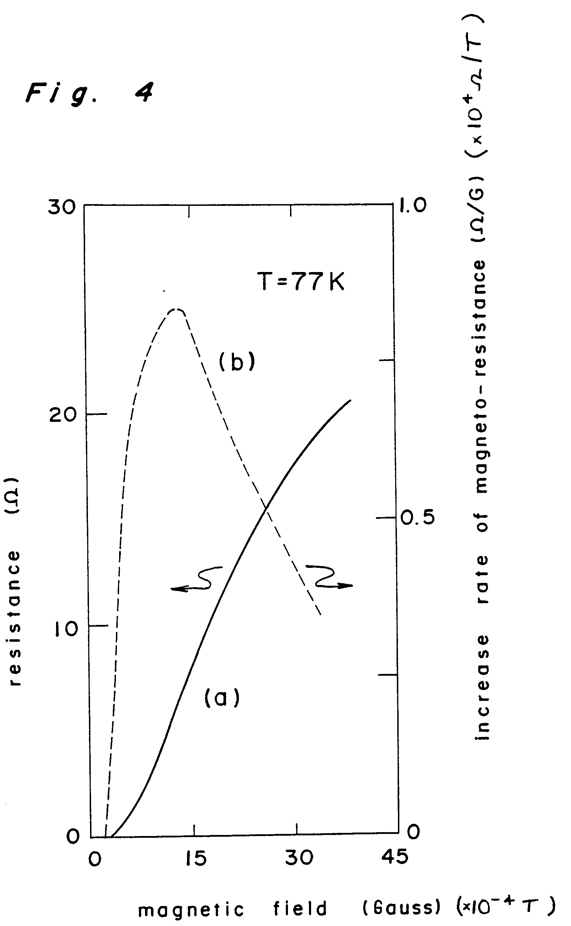

Refer to Fig. 4 showing typical characteristics of a superconductor magneto-resistive element. In Fig. 4, the horizontal axis represents the intensity of the magnetic field applied to the element and the curve (a) in a solid line represents the resistance of the element scaled by the left vertical axis and the curve (b) in dotted lines represents the resistance increase rate of the element against the applied magnetic field scaled by the right vertical axis.

The curve (a) shows that the magneto-resistive element has no resistance when the applied magnetic field is extremely weak and the element has a resistance suddenly when the applied magnetic field exceeds a predetermined intensity and the resistance increases abruptly as the applied magnetic field increases. This characteristic shows that a highly sensitive measurement of a magnetic field can be realised by using the region in the curve (b) where the increase rate of the resistance of the element is abrupt.

Moreover, the curve (a) shows that the relation between the resistance of the element and the intensity of the applied magnetic field is not linear and that it is difficult to calculate the absolute value of the intensity of the applied magnetic field accurately.

In another aspect of the present invention, there is provided a device for sensing a magnetic field using a magneto-resistive element comprising a superconductor member having weak coupling grain boundaries, characterised by the device being provided with means for applying A.C. bias magnetic field to said element, and means for taking out an output voltage of the element generated by application of the bias magnetic field as the signal representing the intensity of the applied magnetic field.

In a further aspect of the present invention, there is provided a device for measuring a weak magnetic field, including a superconductor magneto-resistive element with a non-linear characteristic of resistance against applied magnetic field, characterised by the device further including means for generating a bias magnetic field to be applied to said element, and a feedback control for said generating means to hold an output from the element at a predetermined level, a controlled current supplied by said feedback control providing a measure of the weak magnetic field applied to the element.

BRIEF EXPLANATION OF THE DRAWINGS

Fig. 1 is a schematic diagram showing an arrangement for performing a first embodiment of the method of sensing a magnetic field according to the present invention,

Fig. 2 is a schematic diagram showing an arrangement for performing a second embodiment of the method of sensing a magnetic field according to the present invention,

Fig. 3 is a schematic diagram showing an arrangement for performing a third embodiment of the method of sensing a magnetic field according to the present invention,

Fig. 4 is a schematic diagram showing characteristic curves of the superconductor magneto-resistive element,

Fig. 5 is a schematic diagram showing an example of an arrangement for producing a ceramic superconductor film used in the embodiments of the present invention,

Fig. 6 is a plan view of a superconductor magneto-resistive element employed in the embodiments,

Fig. 7 shows characteristic curves of the superconductor magneto-resistive elements,

Fig. 8 is a schematic diagram showing a general structure of the superconductor magneto-resistive element according to the present embodiments,

Fig. 9 is a plan view showing an embodiment of the superconductor magneto-resistive element,

Fig. 10 is a cross sectional view of Fig. 9,

Fig. 11 is a characteristic curve between D.C. bias and output of the superconductor magneto-resistive element used in the embodiments,

Fig. 12 shows characteristic curves between D.C. bias magnetic field and noise of the superconductor magneto-resistive element,

Figs. 13(a) to 13(f) are schematic diagrams showing output wave forms against the D.C. bias values,

Fig. 14 is a schematic diagram showing the operation point of Fig. 13,

Fig. 15 is a circuit diagram of a lock-in amplifier, and

Fig. 16 is an output characteristic curve of the lock-in amplifier against the D.C. magnetic field.

DETAILED DESCRIPTION OF THE PREFERRED EMBODIMENTS

First, a method of the production of a ceramic superconductor magneto-resistive element used in the following embodiments and its structure and property are explained.

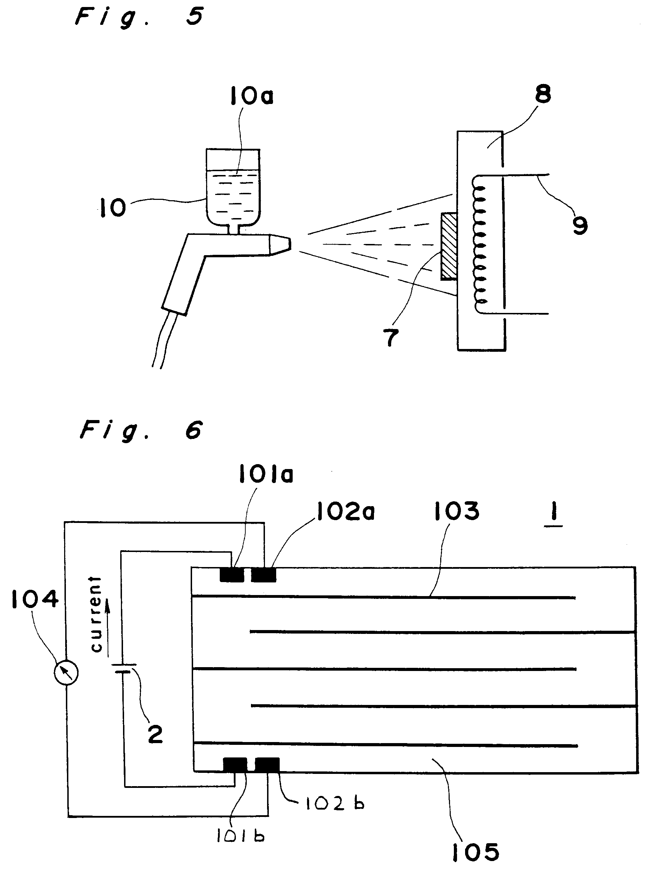

Fig. 5 shows a summary of the production method of the superconductor magneto-resistive element by a spray pyrolysis.

The ceramic superconductor film is made of composition of $YBa_2Cu_3O_{7-\delta}$ and a substrate 7 made of stabilized zirconia on which the ceramic superconductor film is formed is placed on a base plate 8 heated at 350°C by a heater 9. On the other hand, compositions of nitrate of elements of the ceramic superconductor represented by $Y(NO_3)_3.6H_2O$, $Ba(NO_3)_2$ and $Cu(NO_3)_2.H_2O$ are measured and dissolved in solution 10a and the solution is saved in a tank of a sprayer 10. The saved solution is made to fine moisture under high pressure air or high pressure nitrogen gas by the sprayer 10 and sprayed onto the substrate 7. The moisture reaching the substrate 7 forms a ceramic layer by the heat of the substrate 7. The ceramic layer is annealed in air at 950°C for 5 minutes, whereby the film having superconductive characteristics is obtained. The superconductor layer thus obtained showed a resistance property that was decreased from IOOK and the resistance was lost at 81K and brought into the superconductive state.

The superconductor film formed as mentioned above is made in a meander shape by cutting the superconductor film with slits 103 by a machine as shown in Fig. 6, and current terminals IOIa and IOIb and voltage electrodes 102a and 102b are formed on the superconductor film by vaporising Ti. This film is installed and sealed in a package made of anti-magnetic material with dry nitrogen gas so that the superconductor magneto-resistive element 1 is obtained.

The current terminals IOIa and IOIb are connected to a stabilized current source 2 to flow a constant current and the resistance generated in the superconductor magneto-resistive element 1 is measured by a voltage generated across the voltage terminals 102a and 102b which is measured by a volt meter 104.

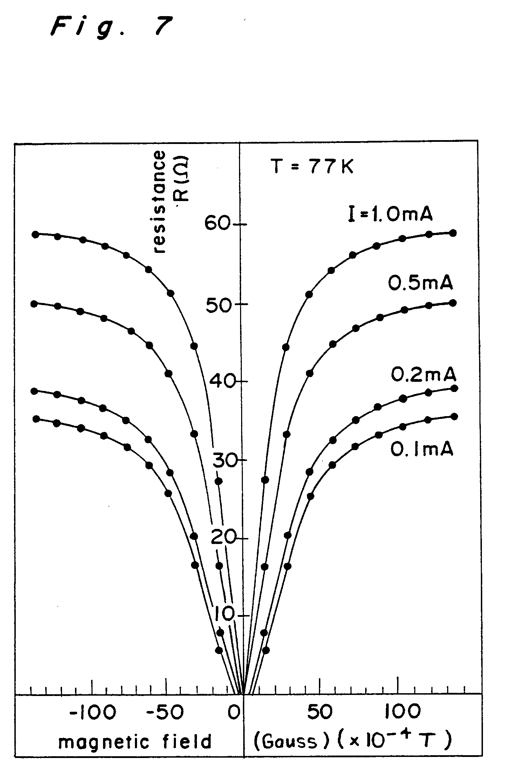

Fig. 7 shows a characteristic by changing the bias current of the superconductor magneto resistive element 1. Fig. 7 is a graph measured when the element is held at 77K of liquid helium temperature, the horizontal axis corresponds to the intensity of the magnetic field applied to the element 1 and the vertical axis to the resistance generated in the element 1. The current values attached to the respective curves are the bias currents applied to the element 1 through the current terminals IOIa and IOIb. As understood from the graphs of Fig. 7, the magneto-resistance generated in the element 1 increases in correspondence with the increase of the bias current and the critical magnetic field at which the resistance occurs is decreased.

First embodiment

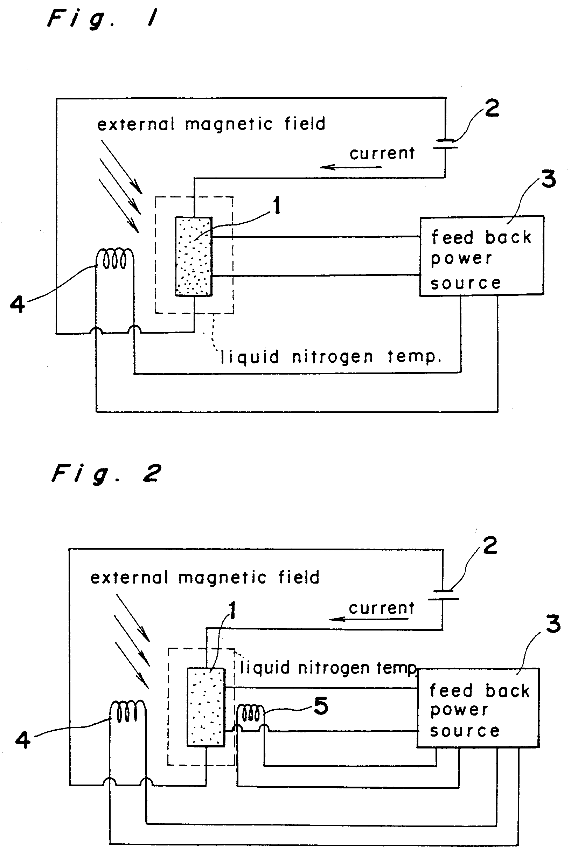

Fig. 1 shows the first embodiment according to the present invention which uses the superconductor magneto-resistive element 1.

The embodiment is such that the output voltage of the element 1 is measured and a feedback current is flown through a bias magnet field coil 4 so as to hold the output voltage of the element 1 constant, whereby the external magnetic field is measured by the bias current value.

In the embodiment shown in Fig. 1, the element 1 is cooled at 77K and a current ImA is supplied to the element 1 from the stabilized current source 2. The output voltage by the application of the external magnetic field is inputted to the feedback source 3. The input voltage is compared to a reference voltage and the feedback power source 3 controls the current flowing in a coil 4 which applies a bias magnetic field to the element 1 so that the difference between the input voltage and the reference voltage is as small as possible.

The coil 4 has a structure that a copper wire is wound in ten turns so that there can be obtained $10^{-3}T/A$ (10 gauss/A) of the magnetic field applied to the element 1 against the current passed by the coil 4.

In the measuring device as mentioned above, the standard output voltage of the element 1 was set at 2 mV and the current to the coil 4 for applying the magnetic field was controlled so as to decrease the difference from the standard voltage by operating the feedback power source 3. In the arrangement of the first embodiment, since the current resolution was $IO\mu A$, due to the noise level, the magnetic resolution in the first embodiment was $10^{-8}T$ ($10^{-4}$ gauss).

Second embodiment

The second embodiment of the present invention is shown in Fig. 2.

The second embodiment is substantially the same as the first embodiment except that a modulation magnetic coil 5 is added so as to apply an A.C. bias magnetic field to the element in addition to the D.C. bias magnetic field, and that only the A.C. voltage component of the output voltage of the element 1 is supplied to the feedback source 3 so that the current to the coil 4 for applying the bias magnetic field is controlled so as to hold the output voltage of the element 1 equal to the standard voltage. The operation of the device is substantially the same as that in the first embodiment except for the above two points and the explanation of the same operation is herein omitted.

In the second embodiment, an output voltage of amplitude of A.C. 2 mV was obtained in the element 1 when A.C. current of ImA peak value, 100 Hz was supplied to the modulation coil 5. The A.C. output could be amplified in synchronism with the period of the modulation magnetic field and the effect of noise could be reduced, whereby the magnetic resolution could be made to $10^{-9}$ T ($10^{-5}$ gauss).

Third embodiment

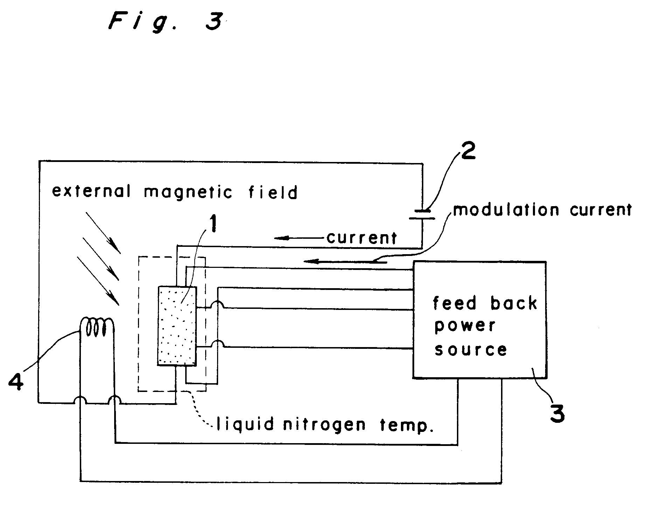

Fig. 3 shows the third embodiment of the present invention. The third embodiment is substantially the same as the first embodiment except that A.C. modulated current is added to the bias current and that only the A.C. component is taken from the element 1, i.e. the same as in the second embodiment. The output from the element 1 was synchronously amplified, and the magnetic field resolution was 5 x $10^{-9}$ T (5 x $10^{-5}$ gauss) by the noise by the bias current of the element 1.

The above embodiments are mentioned only as examples of performing the method of magnetic field sensing using the superconductor magneto-resistive effect according to the present invention, but the method according to the present invention is not limited to the specific details of the above embodiments.

Although the ceramic superconductor film of the superconductor magneto-resistive element in the above embodiments is explained by Y - Ba - Cu - 0 film made by the spray pyrolysis method, the materials may be any superconductor materials of Bi - Sr - Ca - Cu - 0 and T$l$ - Ba - Ca - Cu - 0 so long as the materials have weak coupling at the grain boundaries and a high non-linear sensitivity against the magnetic field, and there may be used the sputter method, electron beam method or CVD method as the film forming method.

Fourth embodiment

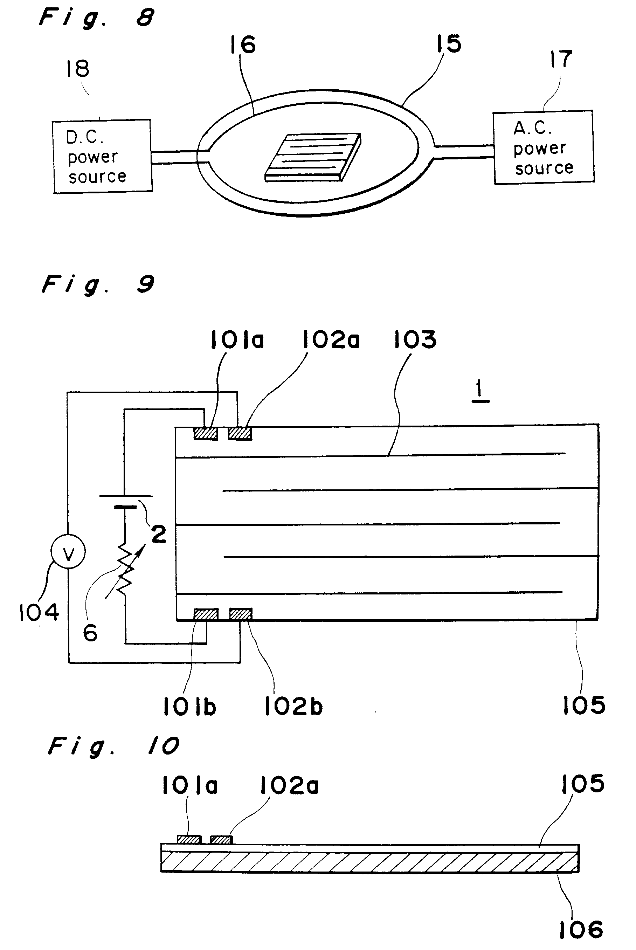

Fig. 9 shows a further example of the superconductor magneto-resistive element used in the fourth embodiment of the present invention in which the element 1 per se is substantially the same as the element shown in Fig. 6, except that the stabilized current source 2 is connected to the element 1 through a current controller 6. The like parts in Fig. 6 and Fig. 9 are numbered with like reference numerals and the detailed explanation thereof is herein omitted.

The ceramic superconductor film in this embodiment was made in such a manner that $Y(NO_3)_3.6H_2O$, $Ba(NO_3)_2$ and $Cu(NO_3)_2.H_2O$ were measured and dissolved in solution and the solution was saved in a tank of a sprayer 10. The saved solution was made to fine moisture under high pressure air or high pressure nitrogen gas by the sprayer 10 and sprayed onto the substrate 7. The moisture reaching the substrate 7 formed a ceramic layer by the heat of the substrate 7 which was heated at 600°C. The superconductor film was made as $10\mu$m thick and was subjected to a thermal treatment in air.

A good result can be obtained when the superconductor film is made with 1 $\mu$m to 10 $\mu$m thick.

The superconductor magneto-resistive element 1 shown in Fig. 9 is set at a centre of two coils 15 and 16, as shown in Fig. 8, which apply bias magnetic fields in the same direction. The measurement by the arrangement shown in Fig. 8 was made in a magnetically shielded room.

The coil 15 is connected to an A.C. power source 17 and the coil 16 is connected to a D.C. power source 18 so as to apply the A.C. magnetic field and the D.C. magnetic field to the element 1.

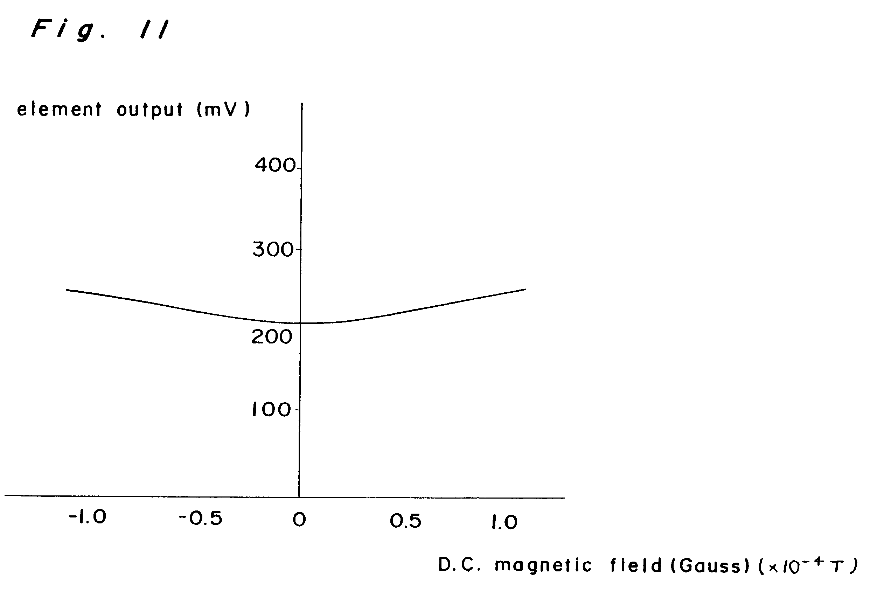

Fig. 11 shows one example of the output characteristic of the element 1 as mentioned above. The output characteristic in Fig. 11 was obtained under such a condition that a bias current of 10 mA was supplied to the current terminals 101a and 101b of the element 1 and the D.C. bias magnetic field is applied by the coil 16. The vertical axis of Fig. 11 shows the output of the element 1 and the horizontal axis of Fig. 11 shows the intensity of the D.C. bias magnetic field.

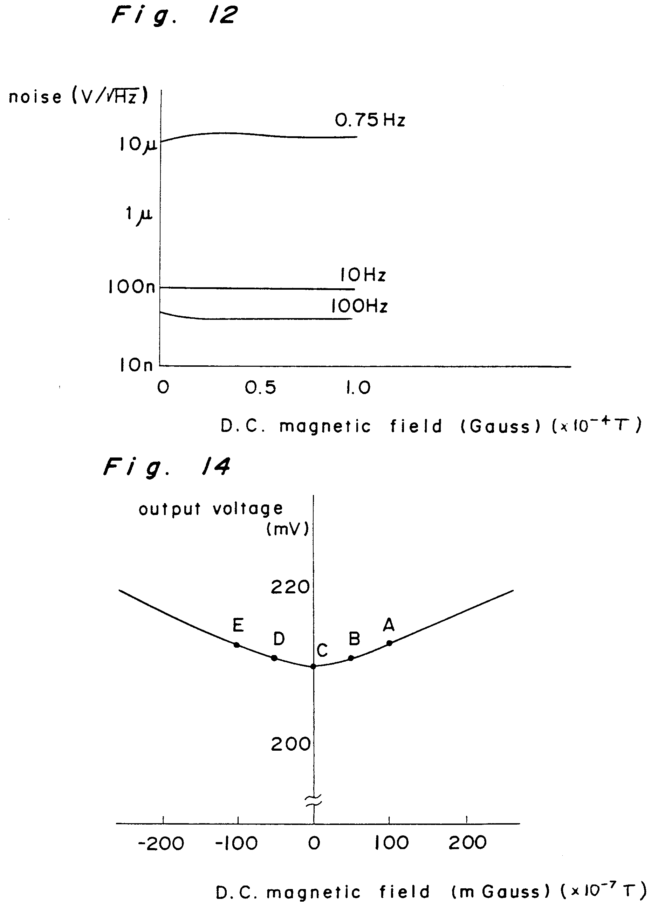

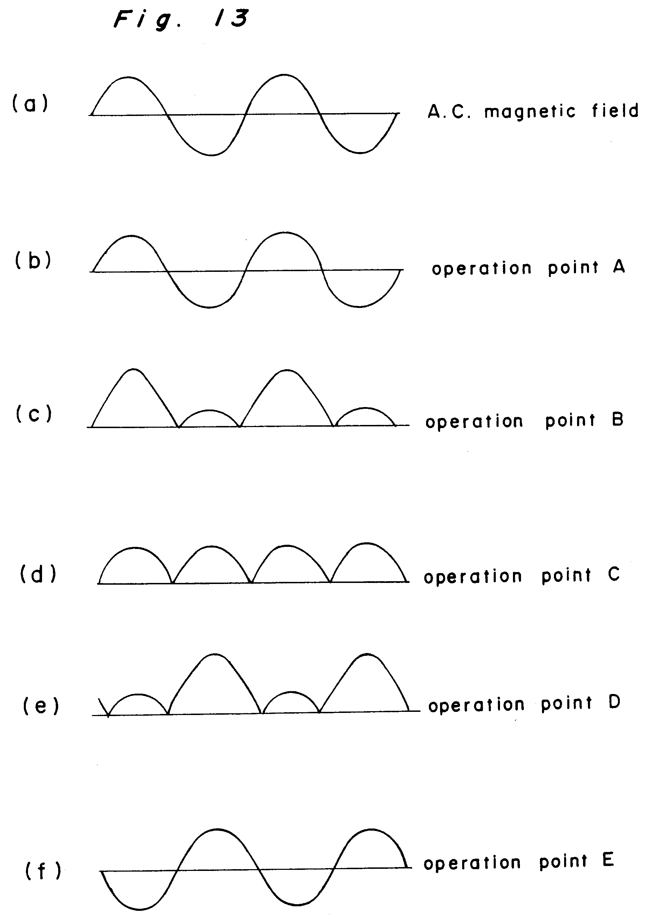

In Fig. 12, the vertical axis of the graph shows intensity of noise included in the output of the element 1 at various frequencies when the element is operated under the same condition as shown in Fig. 11 with the D.C. bias magnetic field changed as shown in the horizontal axis in Fig. 12.

From Fig. 12, it is understood that the change of the noise of the element 1 by the change of the intensity of the applied magnetic field is small but the noise at a low frequency below several hertz is relatively large, whereby Fig. 12 shows that a precise measurement of D.C. and low frequency magnetic field is difficult.

According to the present embodiment, D.C. and low frequency magnetic field can be precisely measured without the effect of the noise by the measurement method shown in the various embodiments already mentioned.

Figs. 13(a) to (f) show A.C. waveforms in one example of the present invention with the arrangement shown in Fig. 8 in which a sinusoidal magnetic field of ±100 x $10^{-7}$ T (±100 milligauss) of 100 Hz as shown in Fig. 13(a) is applied to the element 1 by the coil 15.

Under the condition that the A.C. current is supplied to the coil 15, a predetermined D.C. current is supplied to the coil 16. When various intensities of the D.C. bias magnetic field shown by the points A, B, C, D and E in Fig. 14 having the characteristics explained in relation to Fig. 11 are applied, the waveforms generated at the output of the element 1 corresponding to the above intensities of the magnetic field are as shown in Figs. 13(b), (c), (d), (e) and (f).

The outputs as mentioned above and the A.C. magnetic field generating signals are inputted to a lock-in amplifier, and since only 100 Hz component is taken out with a narrow band, it becomes possible to suppress the effective value of the noise.

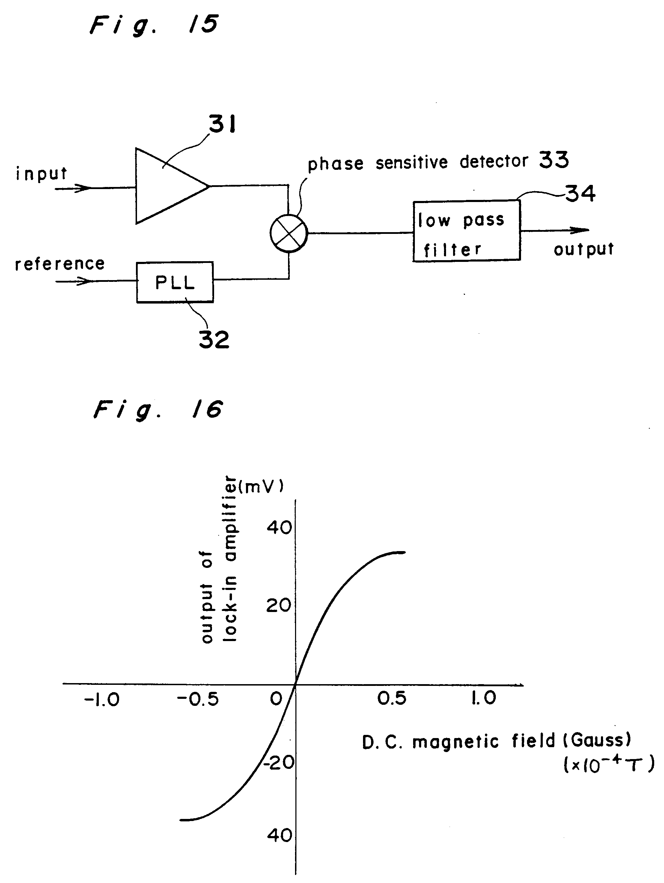

The general structure of the lock-in amplifier is shown in Fig. 15. The output from the voltage terminals 102a and 102b of the element 1 is amplified by 20 times with an amplifier 31 and inputted to the lock-in amplifier. On the other hand, the 100 Hz signal of the sine wave generator is used as the reference input.

32 denotes a phase locked loop to which a reference voltage is supplied.

The principle of the lock-in amplifier is as follows.

It is assumed that the input signal Vs and the reference signal Vr are represented by the following equations:

$$Vr = A \cos (\omega r\, t + \Theta) \qquad (1)$$

$$Vs = \cos (\omega s\, t) \qquad (2)$$

wherein A : constant, $\omega r$ : angular speed of the reference signal , $\Theta$ : phase angle, $\omega s$ : angular speed of the input signal.

By multiplying the above two equations in a phase sensitive detector 33, the following signal Vpsd can be obtained:

$$Vpsd = A\cos(\omega rt+\theta).\cos(\omega st)$$
$$= A/2\cos[(\omega r+\omega s)t+\theta]+A/2\cos[(\omega r-\omega s)t+\theta] \qquad (3)$$

Since $\omega r = \omega s$, the second term of the equation (3) becomes D.C. component. Since the A.C. component of the first term of the equation (3) is eliminated by a low pass filter 34, the output $V_{LP}$ from the low pass filter 34 is:

$$V_{LP} = A/2 \cos \Theta.$$

In order to make $V_{LP}$ maximum, the lock-in amplifier is adjusted so as to make the phase difference of the reference signal and the input signal 0. As mentioned above, it is possible to take out the D.C. component from the frequency component by the A.C applied magnetic field.

By taking the horizontal axis as the intensity of the D.C. bias magnetic field when the current supplied to the coil 16 is changed and taking the vertical axis as the output of the lock-in amplifier, the result of the measurement is shown in Fig. 16. In Fig. 16, the differential magnetic sensitivity of the operation point by the applied D.C. magnetic field is measured as the lock-in amplifier output. However, when the D.C. magnetic field is nearly zero, the waveforms are depicted as Figs. 13(c), (d), (e) by the output property of the superconductor magneto-resistive element 1, and it is found that there is a linear portion in the present embodiment. In the device of the present invention, magnetic fields of D.C to several hertz can be measured with a resolution of $0.1 \times 10^{-7}$ T (0.1 milligauss) by setting the time constant of the low pass filter 34 as 100 milliseconds using the linear portion.

The present invention is not limited to the above embodiment but it is possible to change the measurement range of the magnetic field to be measured and the accuracy of the measurement by adjusting the bias current to the superconductor magneto-resistive element, intensity of the A.C. bias current, its frequency or presence and absence of the D.C bias magnetic field and change of the intensity of the D.C. bias magnetic field.

The A.C bias magnetic field and D.C bias magnetic field may be generated by one coil by supplying A.C current and D.C. current to one coil.

Also, it is possible to sense a magnetic field whose frequency is more than several hertz by adjusting the time constant of the low pass filter of the lock-in amplifier.

It is possible to provide the coil for applying the bias magnetic fields in the thin film shape on the substrate on which the superconductor magnetic resistive element is provided, whereby it is possible to stabilize the magnetic field sensing operation and to facilitate manufacturing of the magnetic field sensing device.

There are described above novel features which the skilled man will appreciate give rise to advantages. These are each independent aspects of the invention as defined by the appended claims.

**Claims**

1. A method of sensing a magnetic field using a magneto-resistive element (1) having a superconductor magneto-resistive effect of non-linear characteristic of resistance against applied magnetic field, characterised by applying a bias magnetic field to said magneto-resistive element using a coil (4;16), said coil being connected to a feedback power source (3) for supplying current thereto for holding the output of said element at a constant value, whereby the applied magnetic field is measured by the current supplied to said coil.

2. The method according to claim 1, comprising applying A.C. bias magnetic field to said magneto-resistive element using a further coil (5;15).

3. The method according to claim 1, wherein said magneto-resistive element is supplied with A.C current.

4. A device for sensing a magnetic field using a magneto-resistive element (1) comprising a superconductor member having weak coupling grain boundaries, characterised by said device comprising means (5; 15,17) for applying A.C. bias magnetic field to said element, and means (102a, 102b) for taking out an output voltage of the element generated by application of the bias magnetic field as the signal representing the intensity of the applied magnetic field.

5. The device according to claim 5, further comprising means (4; 16,18) for applying D.C. bias magnetic field to said element.

6. A device for measuring a weak magnetic field, including a superconductor magneto-resistive element (1) with a non-linear characteristic of resistance against applied magnetic field, characterised by the device further including means (4) for generating a bias magnetic field to be applied to said element, and a feedback control (3) for said generating means (4) to hold an output from the element at a predetermined level, a controlled current supplied by said feedback control providing a measure of the weak magnetic field applied to the element.

**Patentansprüche**

1. Verfahren zum Messen eines Magnetfelds unter Verwendung eines Magnetowiderstandselements (1) mit Supraleiter-Magnetowiderstandseffekt mit nichtlinearer Eigenschaft des Widerstands in bezug auf das angelegte Magnetfeld, **dadurch gekennzeichnet**, daß an das Magnetowiderstandselement ein Vormagnetisierungsfeld unter Verwendung einer Spule (4; 16) angelegt wird, die mit einer Rückkopplungsspannungsquelle (3) verbunden ist, um ihm Strom zum Beibehalten des Ausgangssignals des Elements auf einem konstanten Wert zuzuführen, wobei das angelegte Magnetfeld durch den der Spule zugeführten Strom gemessen wird.

2. Verfahren nach Anspruch 1, bei dem an das Magnetowiderstandselement ein Wechselspannungs-Vormagnetisierungsfeld unter Verwendung einer weiteren Spule (5; 15) angelegt wird.

3. Verfahren nach Anspruch 1, bei dem das Magnetowiderstandselement mit Wechselstrom versorgt wird.

4. Vorrichtung zum Messen eines Magnetfelds unter Verwendung eines Magnetowiderstandselements (1), mit einem supraleitenden Teil mit schwach koppelnden Korngrenzen, **dadurch gekennzeichnet**, daß die Vorrichtung eine Einrichtung (5; 15, 17) zum Anlegen eines Wechselstrom-Vormagnetisierungsfelds an das Element sowie eine Einrichtung (102a, 102b) aufweist, um dem Element eine Ausgangsspannung, wie sie durch Anlegen des Vormagnetisierungsfelds erzeugt wird, als Signal zu entnehmen, das die Stärke des angelegten Magnetfelds repräsentiert.

7

**5.** Vorrichtung nach Anspruch 5, ferner mit einer Einrichtung (4; 16, 18) zum Anlegen eines Gleichstrom-Vormagnetisierungsfelds an das Element.

**6.** Vorrichtung zum Messen eines schwachen Magnetfels, mit einem supraleitenden Magnetowiderstandselement (1) mit nichtlinearer Charakteristik zwischen dem Widerstand und dem angelegten Magnetfeld, **dadurch gekennzeichnet**, daß die Vorrichtung ferner eine Einrichtung (4) zum Erzeugen eines an das Element anzulegenden Vormagnetisierungsfeldes sowie eine Rückkopplungssteuerung (3) für die Erzeugungseinrichtung (4) aufweist, um das Ausgangssignal des Elements auf einem vorgegebenen Wert zu halten, wobei von der Rückkopplungssteuerung ein eingestellter Strom zugeführt wird, der ein Maß für ein an das Element angelegtes schwaches Magnetfeld ist.

## Revendications

**1.** Procédé pour détecter un champ magnétique en utilisant un élément magnéto-résistif (1) ayant un effet magnéto-résistif supraconducteur de caractéristique de résistance non-linéaire par rapport à un champ magnétique appliqué, caractérisé par le fait d'appliquer un champ magnétique de polarisation audit élément magnéto-résistif en utilisant une bobine (4; 16), ladite bobine étant connectée à une source d'alimentation de contre-réaction (3) qui lui fournit du courant afin de maintenir la sortie dudit élément à une valeur constante, de sorte que le champ magnétique appliqué est mesuré par le courant fourni à ladite bobine.

**2.** Procédé selon la revendication 1, comprenant une application d'un champ magnétique alternatif de polarisation audit élément magnéto-résistif en utilisant une bobine supplémentaire (5; 15).

**3.** Procédé selon revendication 1, dans lequel ledit élément magnéto-résistif est alimenté avec du courant alternatif.

**4.** Dispositif pour détecter un champ magnétique en utilisant un élément magnéto-résistif (1) comprenant un élément supraconducteur ayant de faibles frontières de couplage de grain, caractérisé en ce qu'il comprend des moyens (5; 15, 17) pour appliquer un champ magnétique alternatif de polarisation audit élément, et des moyens (102a, 102b) pour extraire une tension de sortie de l'élément engendrée par l'application du champ magnétique de polarisation en tant que signal représentant l'intensité du champ magnétique appliqué.

**5.** Dispositif selon la revendication 5, comprenant également des moyens (4; 16, 18) pour appliquer un champ magnétique continu de polarisation audit élément.

**6.** Dispositif pour mesurer un champ magnétique faible comprenant un élément magnéto-résistif supraconducteur (1) avec une caractéristique de résistance non-linéaire par rapport au champ magnétique appliqué, caractérisé en ce qu'il comprend également des moyens (4) pour engendrer un champ magnétique de polarisation à appliquer audit élément, et une commande de contre-réaction (3) pour lesdits moyens pour engendrer (4) afin de maintenir une sortie provenant de l'élément à un niveau prédéterminé, un courant commandé délivré par ladite commande de contre-réaction fournissant une mesure du champ magnétique faible appliqué à l'élément.

*Fig. 1*

external magnetic field

current

2

1

3

feed back
power
source

4

liquid nitrogen temp.

*Fig. 2*

external magnetic field

current

2

1

3

liquid nitrogen temp.

feed back
power
source

4

5

## Fig. 3

external magnetic field

modulation current

current

feed back power source

liquid nitrogen temp.

*Fig. 4*

# Fig. 5

# Fig. 6

Fig. 7

*Fig. 8*

*Fig. 9*

*Fig. 10*

Fig. 11

element output (mV)

D.C. magnetic field (Gauss) $(\times 10^{-4} T)$

EP 0 406 024 B1

*Fig. 12*

noise (V/√Hz)

0.75 Hz

10μ

1μ

10Hz

100n

100Hz

10n

0        0.5        1.0

D.C. magnetic field (Gauss) ($\times 10^{-4}$ T)

*Fig. 14*

output voltage (mV)

220

E   D   C   B   A

200

-200   -100   0   100   200

D.C. magnetic field (m Gauss) ($\times 10^{-7}$ T)

Fig. 13

(a)      A.C. magnetic field

(b)      operation point A

(c)      operation point B

(d)      operation point C

(e)      operation point D

(f)      operation point E

Fig. 15

Fig. 16